# EUROPÄISCHE PATENTSCHRIFT

(11) **EP 1 382 072 B1**
(45) Veröffentlichungstag und Bekanntmachung des Hinweises auf die Patenterteilung: **26.03.2014**
(21) Anmeldenummer: 02735234.3
(22) Anmeldetag: 08.04.2002
(51) Int. Cl.: H01L 31/18, H01L 27/142

(54) **VERFAHREN ZUR HERSTELLUNG EINER HALBEITERSCHALTUNG**
METHOD FOR PRODUCING A SEMICONDUCTOR CIRCUIT
PROCEDE DE PRODUCTION D'UN CIRCUIT SEMI-CONDUCTEUR

(30) Priorität: 09.04.2001 DE 10117717
(43) Veröffentlichungstag der Anmeldung: 21.01.2004
(73) Patentinhaber: Bayerisches Zentrum für Angewandte Energieforschung e.V. ZAE Bayern, 91058 Erlangen (DE)
(72) Erfinder: BRENDEL, Rolf, 91058 Erlangen (DE)
(74) Vertreter: Manitz, Finsterwald & Partner GbR
(86) Internationale Anmeldenummer: PCT/EP2002/003872
(87) Internationale Veröffentlichungsnummer: WO 2002/082558

(56) Entgegenhaltungen:
- EP-A- 0 840 381
- WO-A-98/13882
- US-A- 5 244 817
- US-A- 5 330 918
- SCHROPP R E I ET AL: "NOVEL AMORPHOUS SILICON SOLAR CELL USING A MANUFACTURING PROCEDURE WITH A TEMPORARY SUPERSTRATE" , AMORPHOUS AND HETEROGENEOUS SILICON THIN FILMS: FUNDAMENTALS TO DEVICES - 1999. SAN FRANCISCO, CA APRIL 5 - 9, 1999, MATERIALS RESEARCH SOCIETY SYMPOSIUM PROCEEDINGS. VOL. 557, WARRENDALE, PA: MRS, US, VOL. VOL. 557, PAGE(S) 713-718 XP000895243 ISBN: 1-55899-464-5 siehe ganzes Dokument

## Beschreibung

Die vorliegende Erfindung betrifft ein Verfahren zur Herstellung einer Halbleiterschaltung sowie nach diesem Verfahren-hergestellte Halbleiterschaltungen.

Solarzellen, Treibertransistoren für Flachbildschirme oder integrierte logische Schaltungen, die aus vielen Bauelementen bestehen, können kostengünstiger hergestellt werden, wenn Sie in einer Dünnschichttechnik anstatt mit dicken Halbleiterscheiben ausgeführt werden. Für den Bereich des kristallinen Siliziums sowie für GaAs werden Schichttransfertechniken entwickelt, welche die Herstellung von elektronischen Bauelementen in nur 1 bis 150 µm dünnen monokristallinen Silziumschichten ermöglichen. Einen Überblick über den Stand der Technik bei den Transfertechniken für den Halbleiter Si gibt der Vortrag von Dr. Rolf Brendel mit der Bezeichnung "Layer transfer processes for crystalline thin-film Si solar cells: a review" veröffentlicht durch das National Renewable Energy Laboratory: Proc. 10th Workshop on Crystalline Silicon Solar Cells Materials and Processes, Redaktion B.L. Sopori, (NREL, Golden 2000), Seite 117.

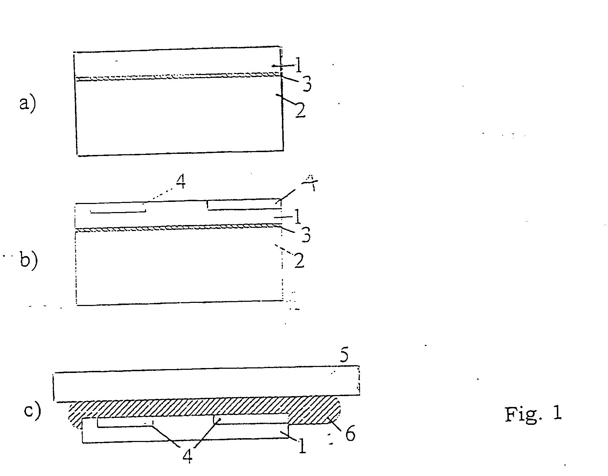

Das Prinzip der Transfertechnik ist, zusammen mit einem beispielhaften Anwendungsfall, in Fig. 1 skizziert:
a) Eine dünne Halbleiterschicht 1 wird auf einem Substrat 2 erzeugt. Eine spezielle Oberflächenbehandlung des Substrates 2 bewirkt das Ausbilden einer Trennschicht 3, die zunächst für eine Verbindung der Halbleiterschicht 1 mit dem Substrat 2 sorgt. Dies ist wichtig, weil die dünne Halbleiterschicht 1 ohne die Unterstützung durch das Substrat 2 mechanisch nicht stabil ist und daher leicht zerbrechen würde. Die Schicht 3 könnte beispielsweise als poröse Schicht ausgebildet werden, die auf einem Si-Substrat 2 vor Herstellung der Schicht 1 erzeugt wird, wie in WO 99/01893 oder in EP-A-0797258 beschrieben.
b) Die Trennschicht 3 wird so stabil ausgeführt, daß es möglich ist, elektronische Bauelemente in die Schicht 1 hinein zu prozessieren. Die Problemstellung sowie die Erfindung wird anhand von Bauelementen in Form von pn-Dioden illustriert. Wir nehmen auch an, daß die Halbleiterschicht 1 p-Typ dotiert ist. Teile der p-Typ dotierten Schicht bilden später die Bereiche der Dioden, die hier Basis genannt werden. Die mit 4 gekennzeichneten Bereiche der Halbleiterschicht 1 seien lokal n-Typ dotiert. Diese Bereiche 4 werden später die Teile von Dioden, die hier Emitter genannt werden. In unserem Beispiel sollen zwei Dioden hergestellt werden. Beispielhaft wird zudem angenommen, daß zusätzlich eine Serienverschaltung zweier Dioden hergestellt werden soll. Die Notwendigkeit hierzu besteht zum Beispiel in photovoltaischen Solarmodulen zur Erhöhung der Ausgangsspannung.
c) Die Schicht 1 wird mit den Emitterbereichen 4 auf einen Träger 5 transferiert. Für die Befestigung der dünnen Schicht 1 kann ein Kleber 6 verwendet werden. Die Emitter 4 sind nach dem Verbinden von Schicht 1 und Träger 5 nicht mehr frei zugänglich. Im Ausgangszustand sind die Basen der Dioden miteinander verbunden.

Es ist nun aber unbedingt erforderlich einen elektrischen Kontakt zu den Bereichen 4 herzustellen, weil die Dioden sonst nicht benützt werden können. Es ist auch erforderlich, die beiden Basen der Dioden elektrisch zu trennen, da sie sonst nicht unabhängig voneinander genutzt werden können. In diesem Beispiel ist zusätzlich eine Serienverschaltung angestrebt, die im Ausgangszustand nicht vorliegt und auch nicht ohne weiteres zu realisieren ist, weil man an die Emitterbereiche 4 nicht heran kommt und weil die Basen miteinander verbunden sind. Die zu lösenden Probleme sind also die folgenden:
1. Kontakte zu den zunächst unzugänglichen Bereichen 4 herzustellen,
2. dies in einer Art und Weise zu tun, die eine kostengünstige, integrierte (d.h. bei vielen Bauelementen gleichzeitig zu prozessierende) Trennung der Bauelemente ermöglicht,
3. die Kontakte zudem in einer Weise zu realisieren, daß eine kostengünstige integrierte Verschaltung, insbesondere eine Serien- und oder Parallelschaltung möglich ist.

Die in der Literatur bekannten Verfahren, Bauelemente aus Schichttransferverfahren zu kontaktieren und zu verschalten, können grob in zwei Klassen eingeteilt werden: solche Verfahren, welche die vollständige Kontaktierung und Verschaltung vor dem Transfer auf den Träger 5 realisieren und solche Verfahren, welche die vollständige Kontaktierung und Verschaltung nach dem Transfer auf den Träger 5 durchführen.

Die EP-A-0 840 381 offenbart eine Dünnschicht-Halbleiter-Vorrichtung und ein Verfahren und eine Vorrichtung zur Herstellung von Dünnschicht-Sonnenzellenmodulen und ein solches Herstellungsverfahren.

### Kontaktieren und Verschalten vor dem Transfer und Herausführen von Drähten

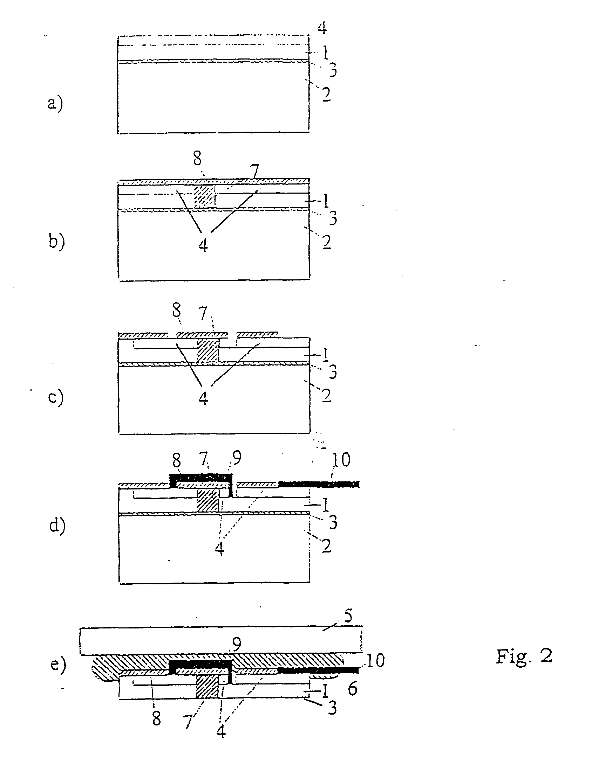

Wird die Kontaktierung und Verschaltung vor dem Transfer durchgeführt, so kann die bekannte Halbleitertechnologie ohne Temperaturbeschränkung durch die thermische Belastbarkeit des Trägers 5 oder des Klebers 6 durchgeführt werden. Einen Lösungsansatz dieser Klasse wird in dem Vortrag von T. Matsushita, S. Miuno, H. Tayanaka and K. Yamauchi "Integrated-type 10 µm thick single crystal silicon solar cells transferred to plastic film" berichtet, der auf Seite 1679 in Proc. 16th European Photovoltaic Solar Energy Conf. abgedruckt ist, die als Buch mit der ISBN Nr. 1-902916-18-2 von James & James, London, Redaktion H. Scheer, B. McNelis, W. Platz, H.A. Ossenbrink and P. Helm herausgegeben wurde. In diesem Vortrag wird die Herstellung eines serienverschalteten Solarmoduls aus monokristallinem Si beschrieben. Die wesentlichen Schritte dieses Prozesses werden nachfolgend anhand der Fig. 2 näher erläutert.
a) Der Prozeß geht von einem nicht strukturierten Emitter 4 aus.
b) Ein Teil der Basisschicht 1 wird durch anodisches Ätzen in einen Trennbereich 7 aus porösem Si umgewandelt und dann durch Oxidation in isolierendes Siliziumoxid umgewandelt. Bei der Oxidation entsteht eine isolierende Schicht 8 aus Siliziumoxid, die den ganzen Emitter abdeckt.
c) Der Isolator 8 wird strukturiert und der Emitter lokal geöffnet, so daß links vom Trennbereich 7 der Emitter und rechts davon die Basis zugänglich sind.
d) Eine Metallverbindung 9 wird lokal aufgebracht, welche den Emitter und die Basis verbindet und so die Serienverschaltung realisiert. Als Technik, einen Kontakt nach außen zu führen, ist das Anbringen eines Drahtes oder einer Metallfolie 9 an eine der Dioden aus dem Vortrag von K. Feldrapp, d. Scholten, S. Oelting, H. Nagel, M. Steinhof, R. Auer und R. Brendel mit der Bezeichnung "Thin monocrystalline Si solar cells fabricated by the porous Si (PSI) process using ion assisted deposition" bekannt, der im obengenannten Buch mit der ISBN 1-902916-18-2 abgedruckt ist. Letzteres Verfahren ist auch in EP-A-0797258 auf Seite 21, Zeile 15 ff. in Bezug auf die Fig. 21 und 22 beschrieben. Die Kontaktierung ist nun vollständig.
e) Die Halbleiterschicht 1 wird mitsamt der vollständigen Kontaktierung 9 unter Zuhilfenahme eines Klebstoffes 6 auf einen Träger 5 transferiert. Ein Draht 10 stellt den Kontakt nach außen her.

Das erläuterte Verfahren hat den Nachteil kompliziert zu sein. Zur Herstellung des Trennbereichs 7 sind eine unvorteilhafte Naßchemie zum Porösätzen und eine kostenintensive Hochtemperatur-Oxidation erforderlich. Wird der Trennbereich 7 zu tief ausgeführt, so wird das Substrat 2 beschädigt, das jedoch mehrfach wiederverwendet werden soll. Das dargestellte Verfahren sieht keine Metallisierung auf der dem Träger 5 abgewandten Seite des Bauelementes vor. Es kann deshalb zu ungünstig hohen Serienwiderständen kommen, insbesondere bei großflächigen Dioden. Eine zusätzliche Metallisierung ist auch nicht ohne weiteres anzubringen, da nach dem Transfer die Metallisierung 9 nicht mehr zugänglich ist. Wird die Verschaltung, wie in EP-A-0797258 mit herausgeführten Drähten durchgeführt, so sind die losen Drähte bei der Prozessierung störend. Sie müssen außerdem einzeln verlötet werden, was dem Grundgedanken einer integrierten Verschaltung zuwider läuft.

### Kontaktieren und Verschalten nach dem Transfer

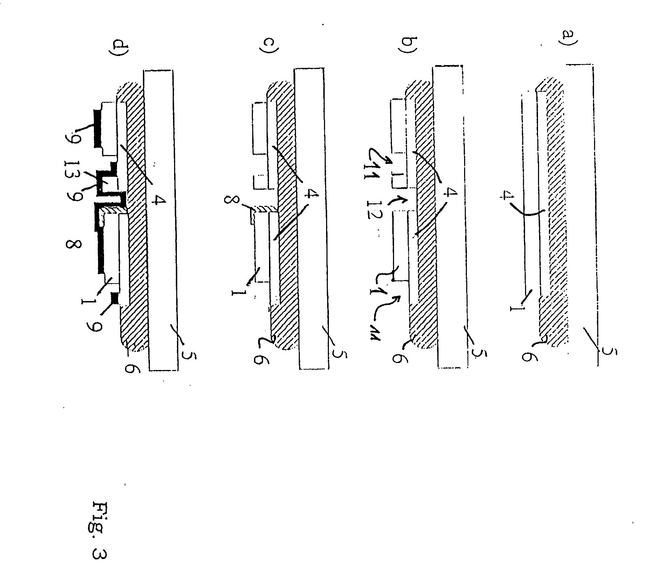

Ein anderes Verfahren besteht im Aufbringen der Metallisierung nach dem Transfer auf der dem Träger 5 abgewandten Seite der Halbleiterschicht 1. Diese Ausgangssituation ist bei der Herstellung von Solarmodulen bekannt, die aus Siliziumschichten aufgebaut sind, welche direkt auf isolierende Substrate (z.B. Keramik) abgeschieden wurden. Beispielsweise wird auf die Technik hingewiesen, die von R. Auer im Aufsatz "Integrierte Verschaltung von kristallinen Silizium-Dünnschicht Solarzellen mit Plasmaprozessen" im Tätigkeitsbericht 1999 des Bayerischen Zentrums für Angewandte Energieforschung e.V. herausgegeben vom Bayerischen Zentrum für Angewandte Energieforschung e.V. (ZAE Bayern), Würzburg, 2000 auf Seite 48 beschrieben ist. Die wesentlichen Schritte dieser Technik sind in Fig. 3 dargestellt.
a) Ausgangspunkt ist eine großflächige Diode mit Emitter 4 und Basis 1 auf einem isolierenden Klebstoff 6.
b) Zum Trennen der Bauelemente wird ein Bereich 12 der Halbleiterschicht 1 entfernt. Hierbei wird die isolierende Schicht 6, hier der Klebstoff 6, als Ätzstopp genutzt. In einem weiteren Prozeßschritt werden die Emitter 4 durch Entfernen von Siliziummaterial in den Bereichen 11 freigelegt.
c) Durch Aufbringen eines Isolators 8 wird der pn-Übergang der rechten Diode überdeckt.
d) Durch Aufbringen von Metallschichten 9 wird die Serienverschaltung sowie der Kontakt nach außen (Anschlüsse des Moduls) realisiert. Ohne den Isolator 8 würde bei diesem Schritt die rechte Diode kurzgeschlossen.

Dieses bekannte Verfahren hat den Nachteil, daß es kompliziert ist, weil die Trennung der Bauelemente und das Freilegen des Emitters in getrennten Prozessen erfolgen. Dies ist unvermeidbar, da in den Bereichen 12 und 11 aus Fig. 3b) unterschiedlich viel Halbleitermaterial zu entfernen ist. Die Kontrolle der Grabentiefe durch die Dauer des Ätzprozesses ist in den Bereichen 11 technisch nur schwer zu realisieren, weil der Emitter in der Regel dünner als 1 µm ist, während die Halbleiterschicht 1 typischerweise mehr als 10-fach so dick ist. Die Ätzraten müßten somit sehr stabil sein um die Ätztiefe über die Ätzzeit zu kontrollieren. Im Falle der Serienverschaltung von Solarzellen ist ein Halbleiterbereich 13 für die Energieumwandlung verloren, da der pn-Übergang in diesem Bereich kurzgeschlossen ist. Für eine Serienverschaltung von Solarzellen ist es weiterhin von Nachteil, daß auf der dem Träger 5 zugewandten Seite keine Metallisierung vorgesehen ist, welche bei großflächigen Dioden den Serienwiderstand der Solarmodule reduzieren kann. Diese Metallisierung ist offensichtlich auch nicht ohne weiteres anzubringen.

### Herstellung lokaler Dotierbereiche

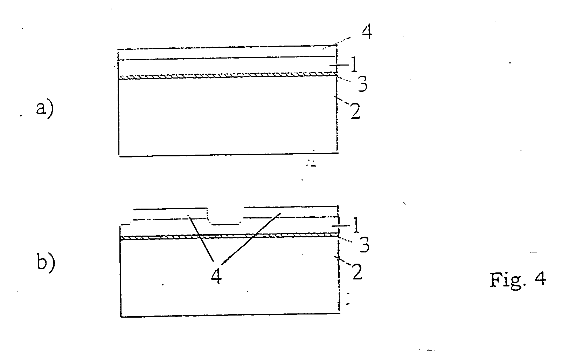

Die Skizze der Problemstellung in Fig.1 geht beispielhaft von lokalen n-Typ Emittern 4 aus, die in eine p-Typ Basis eingebracht wurden. Sollten die Dotierbereiche, wie in Fig. 4a) dargestellt, zunächst ganzflächig erzeugt werden, so ist es Stand der Technik, lokale Emitterbereiche 4 durch Entfernen von Teilbereichen des Emitters herzustellen. Das Entfernen von Teilbereichen des Emitters kann bspw. durch Plasmaätzen, naßchemisches Ätzen oder mechanisches Abtragen erfolgen. Der entstehende Graben muß mindestens die Tiefe des Emitters haben und sollte vorzugsweise etwas tiefer ausgeführt werden. Der Zustand nach dem Auftrennen des Emitters ist in Fig. 4b) dargestellt. Das Ausführungsbeispiel 1 geht von lokalen Emittern aus, während das Ausführungsbeispiel 2 das Herstellen der lokalen Emitter auf die in Fig. 4 dargestellte Weise ausführt.

Aufgabe der vorliegenden Erfindung ist es, ein Verfahren zur Herstellung einer Halbleiterschaltung vorzusehen, das es ermöglicht, Kontakte zu den zunächst unzugänglichen Bereichen herzustellen, dies in einer Art und Weise zu tun, die eine kostengünstige, integrierte (d.h. bei vielen Bauelementen gleichzeitig zu prozessierende) Trennung der Bauelemente ermöglicht und die Kontakte zudem in einer Weise zu realisieren, daß eine kostengünstige integrierte Verschaltung, insbesondere eine Serien- und oder Parallelschaltung möglich ist.

Diese Aufgabe wir durch ein Verfahren gemäß Anspruch 1 bzw. durch ein Verfahren gemäß Anspruch 8 gelöst.

Besonders interessant ist, dass mit diesem Verfahren die Entfernung von Bereichen der Struktur sozusagen von der Rückseite des Substrats oder der Struktur erfolgen kann, wobei die Metallkontakte, der Klebstoff oder eine ggf. vorhandene Passivierung auf der Metallkontaktseite der Struktur als Stoppschicht für diesen Entfernungsvorgang dienen kann. Auf diese Weise gelingt es, die Aufgabe zu lösen. Weiterhin kann man sehr viele verschiedene Weiterbildungen der Erfindung betreiben, die in den Unteransprüchen angegeben sind.

Selbst wenn sich das Verfahren besonders als Transferverfahren eignet, ist die Erfindung hierauf nicht beschränkt, sondern kann auch dann verwendet werden, wenn das Substrat einen Wafer darstellt, der nicht entfernt, sondern auch nach Anbringung der mit Metallkontakten versehenen Seite der Struktur an ein Hilfssubstrat oder nach Ausbildung des Hilfssubstrats durch den Klebstoff beibehalten und ggf. strukturiert wird.

Obwohl das Verfahren mit Si-Halbleitersystemen und -materialien besonders günstig zu realisieren ist, ist es keineswegs auf solche Halbleitermaterialien beschränkt, sondern grundsätzlich auf alle Halbleitersysteme und -materialien anwendbar, wobei die Anwendung auch die Kombination mit den verschiedensten Metallen (bspw. als Kontakte) und Isolatoren (bspw. als Hilfssubstrate) zulässt.

Die Erfindung umfasst auch Halbleiterschaltungen, die nach dem erfmdungsgemäßen Verfahren hergestellt sind.

Die Erfindung wird nachfolgend anhand von Ausführungsbeispielen unter Bezugnahme auf die Zeichnungen näher erläutert, in welchen zeigen:
- Fig. 1-4: verschiedene Stufen von Verfahren nach dem Stand der Technik, die oben erläutert sind und die es zu verbessern gilt,
- Fig. 5 und 6: Stufen eines ersten und eines zweiten Ausführungsbeispiels des erfindungsgemäßen Verfahrens, und
- Fig. 7: eine schematische Darstellung der Anwendung des erfindungsgemäßen Verfahrens nach Ausführungsbeispiel 2 bei der Herstellung eines Solarzellenmoduls.

### Ausführungsbeispiel 1

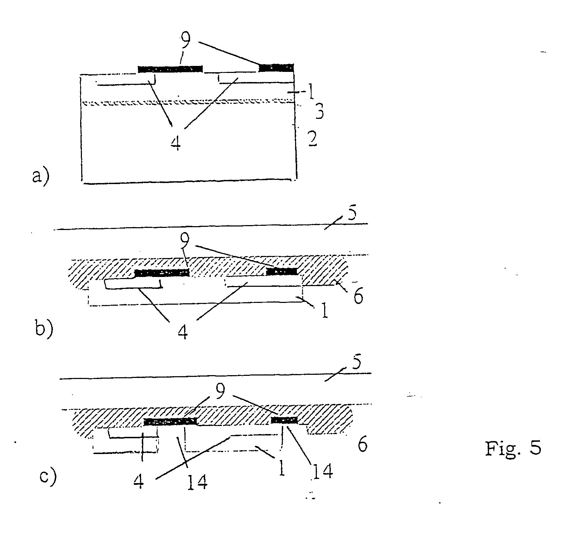

Um die vergrabenen Bauelemente zu kontaktieren, zu verbinden und einen Kontakt nach Außen herzustellen, dabei aber die genannten Nachteile der bekannten Verfahren zu vermeiden, kann wie in Fig. 5 skizziert vorgegangen werden.
a) Zunächst werden Metallkontakte 9, z.B. durch Aufdampfen, Siebdrucken oder Bonden aufgebracht. Die linke Diode ist kurzgeschlossen.
b) Mit den Kontakten 9 wird die Halbleiterschicht 1 auf den Träger 5 transferiert. Die Metallkontakte 9 sind ab diesem Zeitpunkt nicht mehr zugänglich.
c) Bereiche 14 der Halbleiterschicht 1 werden entfernt. Dies geschieht vorzugsweise durch Plasmaätzen. Geeignete Plasmaätzprozesse sind im Vortrag von R. Auer, V. Azuz, J. Ackermann, W. Kintzel, R. Brendel and M. Schulz mit der Bezeichnung "Large area plasma processes for internally series connected thin film solar cells" beschrieben, der im oben genannten Buch mit der ISBN 1-902916-18-2 auf Seite 1691 wiedergegeben ist. Metall, zum Beispiel Aluminium, wird dabei vom Plasma nicht geätzt. Eine zu lange Ätzdauer führt daher nichtzu einer Zerstörung der Kontakte 9.
   Die Metallkontakte 9 werden durch den Ätzschritt bereichsweise bzw. stellenweise freigelegt. Der Ätzbereich kann so positioniert werden, daß nur das Metall 9 frei gelegt wird (linke Diode), oder so, daß sowohl das Metall 9 als auch der Kleberstoff 6 freigelegt werden (rechte Diode). Als Klebstoff können u.a. Silikone oder Kunststoffkleber verwendet werden. Dieser eine Ätzschritt, welcher die Bereiche 14 freilegt, hat somit drei Konsequenzen: Der Kurzschluß der linken Diode ist beseitigt, eine Serienverschaltung wird erreicht, und die Dioden sind von außen kontaktierbar.

Im Vergleich zum Stand der Technik ist dieser Prozeß unkompliziert: Nur eine Metallisierung und ein Plasmaätzschritt sind notwendig, um die Problemstellung lösen zu können. Es besteht keine Gefahr das Substrat 2 durch zu langes Ätzen zu beschädigen, weil das Substrat 2 zum Zeitpunkt des Ätzen schon von der Halbleiterschicht 1 getrennt ist. Es werden keine Hochtemperaturprozesse benötigt. Zwischen dem Metallfilm 9 und den halbleitenden Schichten 1 und 4 kann auf Teilflächen auch ein Isolator angebracht sein, der beispielsweise eine teilweise Passivierung der Halbleiteroberfläche bewirkt.

### Ausführungsbeispiel 2

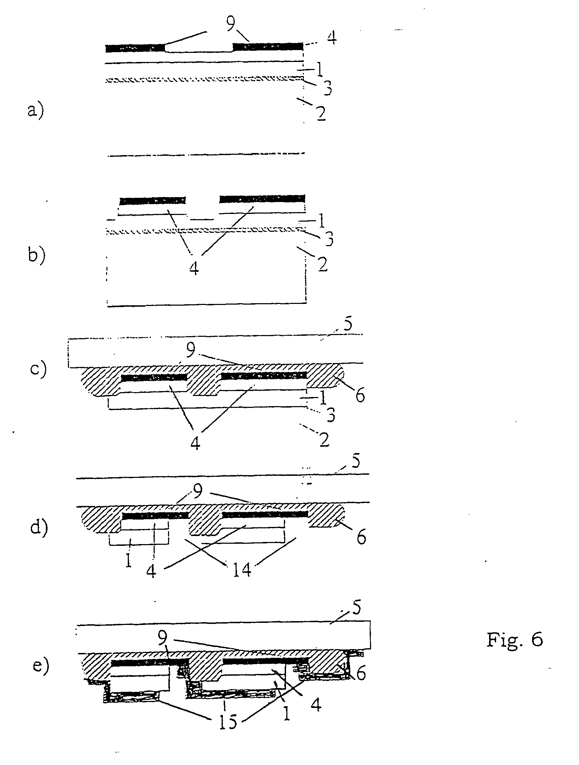

Ein zweites Ausführungsbeispiel zeigt die Fig. 6.
a) Hier wird von einem ganzflächigen Emitter ausgegangen, auf dem Metallkontakte 9 aufgebracht werden.
b) Wie oben unter *Herstellung lokaler Dotierbereiche* dargelegt, werden lokale Emitter durch lokales Entfernen der Emitterschicht 4 hergestellt. Hierbei kann auch das Metall 9 als Ätzmaske dienen.
c) Die so prozessierte Halbleiterschicht 1 wird auf den Träger 5 transferiert. Dazu kann ein Klebstoff 6, z. B. Kunststoff, Silikon oder ein Zweikomponentenkleber, zur Hilfe genommen werden. Die Metallkontakte 9 sind zu diesem Zeitpunkt nicht mehr zugänglich.
d) Bereiche 14 der Halbleiterschicht 1 werden bis zum Metall 9 entfernt. Es ist zweckmäßig, den Ätzprozeß, z. B. das Plasmaätzen, so auszuführen, daß sowohl das Metall 9 als auch der Klebstoff 6 einen Ätzstopp bewirken. Mit diesem Ätzschritt werden die Kontakte 9 teilweise freigelegt und zugänglich gemacht. Gleichzeitig werden benachbarte Dioden voneinander getrennt.
e) Das Verschalten der Dioden ist nun dadurch zu erreichen, daß auch auf der von der dem Träger abgewandten Seite der Halbleiterschicht 1 ein Metall 15 aufgebracht wird. Weil das Metall 15 mit dem Metall 9 eine elektrisch gut leitende Verbindung bildet, ist nun eine elektrische Verbindung zwischen dem Emitter 4 der linken Diode und der Basis 1 der rechten Diode hergestellt. Im gleichen Prozeßschritt kann der Kontakt 9 auch über den Bereich des Klebstoffes 6 hinaus auf den Träger 5 nach außen geführt werden.

Die Nachteile der aus dem Stand der Technik bekannten Verfahren werden vermieden. Das Erzeugen einer isolierenden Schicht 8 kann, muß aber nicht, entfallen, der pn-Übergang wird von dem isolierenden Klebstoff 6 geschützt. Hochtemperaturprozesse sind nicht erforderlich. Die Aufhebung des Kurzschlusses und das Trennen der Dioden werden mit nur einem Ätzschritt erzielt. Die Metallisierung beider Seiten erlaubt die Herstellung eines Solarmoduls mit niedrigem Serienwiderstand.

Das erfindungsgemäße Verfahren kann so ausgeführt werden, daß im Schritt a) eine oder mehrere Zwischenschichten, bspw. eine Schicht oder mehrere Schichten aus intrinsischem Material und/oder aus p- und/oder n-leitenden Material auf dem p-leitenden oder n-leitenden schichtartigen Bereich hergestellt wird bzw. werden. Mit anderen Worten ist die Herstellung von Halbleiterschaltungen mit PIN- oder NIP- Strukturen genauso möglich wie die Herstellung von Halbleiterschaltungen mit Transistoren oder anderen elektronischen Bauteilen, wie auch die Herstellung von Übergitterstrukturen oder Quantenstrukturen. Im Prinzip können alle bekannten elektronischen Strukturen, so auch solche mit passiven Bauteilen, unter Anwendung des Grundprinzips der Erfindung realisiert werden.

Es ist zum Beispiel möglich, auf die freiliegende Fläche der im Schritt a) hergestellten Struktur eine oder mehrere weitere Schichten aufzuwachsen bevor die Metallkontakte nach dem ausgewählten Muster gemäß Schritt b) angebracht werden.

Vor Anbringung der Metallkontakte nach einem ausgewählten Muster gemäß Schritt b) kann eine Passivierung der freiliegenden Fläche der Struktur erzeugt werden.

Der Schritt der Herstellung der Metallkontakte kann darin bestehen eine ganzflächige Metallisierung auf die freiliegende Fläche der Struktur aufzubringen und diese Metallisierung durch ein lithographisches Verfahren oder ein mechanisches Verfahren entsprechend dem ausgewählten Muster bereichsweise zu entfernen.

Nach Durchführung des Schrittes c) kann das Substrat von der Struktur entfernt werden, wonach der Schritt d) durchgeführt wird.

Im Schritt d) kann die Entfernung von Bereichen der Struktur bis zu den erstgenannten Metallkontakten und/oder bis zu einer Passivierung und/oder bis zu dem Klebstoff zurück, durch einen Ätzschritt durchgeführt werden, der an den Metallkontakten bzw. an der Metallisierung und/oder an der Klebstoffschicht und/oder an einer gegebenenfalls vorhandenen Passivierung gestoppt wird.

Der Schritt d) der Aufbringung von weiteren Metallkontakten nach einem weiteren ausgewähltem Muster kann dadurch erfolgen, daß eine Metallisierung ganzflächig auf die von der Rückseite der strukturierten Struktur aufgebracht wird und daß diese Metallisierung gegebenenfalls selbst strukturiert wird, bspw. durch ein mechanisches Abtragverfahren oder durch ein lithographisches Verfahren.

Nach dem Schritt d) kann die aufgebrachte Metallisierung als Maske für die Entfernung von Halbleiterbereichen verwendet werden, die sich zwischen den metallisierten Bereichen befinden.

### Ausführungsbeispiel 3

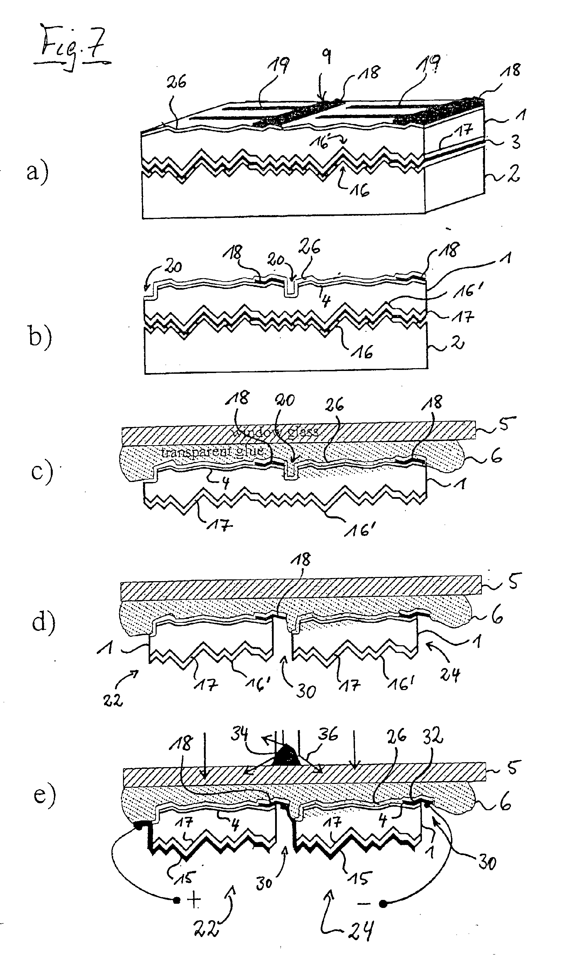

In Fig. 7 ist ein drittes Ausführungsbeispiel gezeigt, bei dem das im zweiten Ausführungsbeispiel beschriebene Verfahren bei der Herstellung von integriert serienverschalteten Dünnschicht-Solarzellen angewandt wird. Dabei zeigt Fig. 7a eine perspektivische Ansicht, während aus Gründen der besseren Übersichtlichkeit die nachfolgenden Fig. 7b bis 7e lediglich eine Querschnittsansicht zweier Zellen zeigen, wobei von den Metallkontakten nur der Kontaktbus dargestellt ist.
a) Ausgangsmaterial ist ein p⁺-dotierter monokristalliner, (100) orientierter Siliziumsubstratwafer 2. Durch chemisches Ätzen wird eine Substratoberfläche mit aufrechtstehenden zufälligen Pyramiden 16 versehen. Auf der texturierten Oberfläche wird elektrochemisch ein poröses Doppelschichtsystem 3 geätzt (vgl. dazu die deutsche Patentanmeldung DE 197 27 791.8).
   Durch Ausheilen in einem Epitaxiereaktor wird die poröse Oberfläche geschlossen (vgl. T. Yonehara et al., "Epitaxial layer transfer by bond and etch back of porous silicon", Appl. Phys. Lett. 1994, 46, Seite 2108) und das poröse Schichtsystem mechanisch geschwächt (vgl. H. Tayanaka, "Separation of thin epitaxial Si film on porous Si for solar cells", Proceedings of the 6th Sony Research Forum, Sony 1996, Seite 556; und H. Tayanaka et al., "Thin-film crystalline Silicon solar cells obtained by separation of a porous silicon sacrificial layer", Proc. 2nd World Conf. on Photovoltaic Energy Conversion, ed. by J. Schmid, H. A. Ossenbrink, P. Helm, H. Ehmann, E. D. Dunlop, Joint Research Center European Comission: Ispra, 1998, Seite 1272).
   Mittels chemischer Gasphasenabscheidung (CVD) bei 1100 °C wird eine 2 µm dicke, 5 x 10¹⁸ cm⁻³ Bor-dotierte Rückseitenfeld- ("backsurface field")-Schicht 17 und darauf eine 15 µm dicke, 1 x 10¹⁷ cm⁻³ Bor-dotierte Basisschicht 1 abgeschieden. Die Oberfläche dieser epitaktischen Schichten ist nahezu eben (vgl. G. Kuchler et al., "Fabrication of textured monocrystalline Si-films using the porous silicon (PSI) process", Proceedings 16th European Photovoltaic Solar Energy Conference; ed. by H. H. Scheer, B. McNells, W. Palz, H.A. Ossenbrink, and P. Helm; James & James: London, 2000; Seite 1695).
   Mittels Phosphordiffusion wird eine ganzflächige Emitterschicht 4 gebildet. Zur Bildung der beispielsweise kammartigen Vorderseitenmetallisierung 9 werden Kontaktbusse 18 und Kontaktfinger 19 aus Aluminium durch eine Schattenmaske hindurch auf die Emitterschicht 4 aufgedampft.
b) Mittels reaktiven Ionenätzens in einem SF_{6/}Ar-Plasma werden durch die Emitterschicht 4 hindurch 3 µm tiefe Trenngräben 20 geätzt. Die Definition der Trenngräben 20 erfolgt durch metallische Masken. Die Ätzrate beträgt etwa 1,5 µm/min. Durch die Gräben 20 werden die lokalen Emitterschichten 4 benachbarter Solarzellen 22, 24 voneinander getrennt.
   Anschließend wird eine Antireflexschicht 26 aufgebracht. Diese kann beispielsweise Siliziumoxid oder Siliziumnitrid aufweisen und ggf. gleichzeitig als Emitter-Oberflächenpassivierung dienen.
c) Nachdem die Solarzellen 22, 24 mittels eines transparenten Klebstoffes 6 an einer unbeschichteten Trägerglasscheibe 5 angebracht worden sind, werden die Solarzellen 22, 24 durch mechanische Belastung von dem Substrat 2 getrennt.
   Nach erfolgter Trennung sind die Rückseiten 28 der Solarzellen 22, 24 für eine weitere Prozessierung zugänglich, während die Vorderseitenmetallisierung 9, 18, 19 unzugänglich ist. Rückstände des temperaturbehandelten porösen Siliziums 3 werden durch Plasmaätzen entfernt. Aufgrund der aufrechten zufälligen Pyramiden 16 auf der Oberfläche des Substratwafers 2 weist die Rückseite 28 der epitaktischen Schicht 1 invertierte zufällige Pyramiden 16' auf (vgl. G. Kuchler et al.).
d) Als nächstes folgt ein einziger reaktiver Ionenätzschritt, bei dem in etwa 12 Minuten mit einer Ätzrate von 1,5 µm/min etwa 1 mm breite Kontaktgräben 30 zwischen benachbarten Solarzellen 22, 24 geätzt werden, wobei der Ätzprozeß sowohl auf der Aluminiumschicht des Vorderseitenkontaktbusses 18 als auch auf dem transparenten Klebstoff 6 stoppt.
   Dieser einzelne Ätzschritt erfüllt drei Aufgaben: Erstens werden die benachbarten Solarzellen 22, 24 elektrisch voneinander getrennt, zweitens wird die äußere Form der Solarzellen 22, 24 definiert und drittens wird ein Zugang zu den Kontaktbussen 18 der Vorderseitenmetallisierung 9 geschaffen.
e) Als letzter Prozeßschritt folgt die Bildung der Rückseitenmetallisierung 15 durch teilweise Bedampfung der p⁺-dotierten Siliziumschicht mit Aluminium mittels einer Schattenmaske. Die Rückseitenmetallisierung 15 kontaktiert den freigelegten Kontaktbus 18 der Vorderseitenmetallisierung 9 und verschaltet dadurch die Solarzellen 22, 24 seriell.
   Der pn-Übergang ist sowohl durch die Antireflexschicht 26 als auch durch den transparenten Klebstoff 6 isoliert, so daß Kurzschlüsse durch die Rückseitenmetallisierung 15 vermieden werden. Das Solarzellenmodul ist an einem freigelegten Kontaktbus 32 der Vorderseitenmetallisierung 9 und an der Rückseitenmetallisierung 15 kontaktierbar. Zur Verringerung der optischen Verluste sind im Bereich der Kontaktgräben 30 auf der den Solarzellen 22, 24 abgewandten Oberfläche der Glasscheibe 5 U-förmige Metallreflektoren 34 angebracht, die das im Bereich der Trenngräben 20 und der Kontaktgräben 30 einfallende Licht 36 neben den Gräben 20, 30 in die Glasscheibe 5 und damit in die Solarzellen 22, 24 lenken.

In einer Abwandlung des Prozeßschemas ist es denkbar, die Rückseite der Solarzellen 22, 24, d.h. die p⁺-dotierte Siliziumschicht 17 mit einer elektrischen Rückseitenpassivierung zu versehen und die Rückseitenmetallisierung 15 nicht ganzflächig sondern nur bereichsweise und in Form beispielsweise eines kammartigen Kontaktmusters auszuführen. Das Solarzellenmodul würde in so einem Fall unter beidseitiger Beleuchtung, d.h. unter gleichzeitiger Beleuchtung der Vorder- und Rückseite Strom erzeugen.

Wird das Solarzellenmodul ausschließlich von der Rückseite beleuchtet, so ist eine teilweise Metallisierung 15 der Rückseite in Form eines kammartigen Basiskontakts und eine annähernd ganzflächige Metallisierung 9 der Emitterschicht 4 denkbar. Eine entsprechend ausgebildete Emittermetallisierung 9 könnte sogar gleichzeitig als Ätzmaske bei der Bildung der Trenngräben 20 dienen.

Ein Vorteil des erfindungsgemäßen Solarzellenprozesses ist, daß die Spannung, die Form und die Größe der Solarzellen sowie auch die Gestalt der Solarzellenverbinder durch eine geeignete Wahl der Masken für das Plasmaätzen und die Metallisierung frei einstellbar sind. Beispielsweise können gekrümmte Trenngräben 20 oder Kontaktgräben 30 zu einem ansprechenderen Aussehen der Solarzellenmodule führen. Solarzellen-Minimodule für verschiedene Anwendungen können in einer Charge prozessiert werden.

Der Schlüsselschritt des erfindungsgemäßen Verfahrens zur seriellen Verschaltung von Solarzellen ist das Ätzen des Grabens 30, das an der Vorderseitenmetallisierung 9 stoppt. Da diese Grabenbildung im Prinzip von der Dicke der Solarzelle unabhängig ist, kann das Verfahren auch auf einen beispielsweise 300 µm dicken Wafer 1, z. B. aus Silizium, angewendet werden, der nach der Prozessierung seiner vorderen Oberfläche mit der Vorderseite auf ein Deckglas 5 geklebt wurde.

Die Zeit, die zur Bildung des Grabens 30 mittels reaktivem Ionenätzen benötigt wird, läßt sich dabei erheblich verringern, wenn zunächst durch mechanischen Abtrag, beispielsweise mittels einer Chipsäge, ein etwa 280 µm tiefer Graben gebildet wird. Die letzten 20 µm können dann mittels Plasmaätzen und unter Verwendung des Ätzstopps auf der Vorderseitenmetallisierung 9 entfernt werden. Ist der Wafer dick genug, so kann ggf. sogar maskenlos geätzt werden, sofern sich auf der Rückseite des Wafers keine Strukturen befinden, die durch das Ätzen beschädigt würden. Wird zum Sägen des Grabens 30 ein keilförmiges Schleifwerkzeug verwendet, so entsteht ein Graben, der sich in den Wafer hinein verjüngt. Die Belegung der Waferoberfläche und insbesondere der Grabenwände mit Metall 15 wird dadurch stark verbessert.

Es wird somit folgendes vorgeschlagen:
- Ein Verfahren zur Kontaktierung und integrierten Verschaltung von teilprozessierten elektronischen Bauelementen in schichtartigen Gebilden, die flächenhaft und möglicherweise oberflächenstrukturiert sind. Das Verfahren zeichnet sich dadurch aus, daß vor dem Aufbringen des schichtartigen Gebildes auf einen Träger die elektronischen Bauelemente ganz oder teilweise mit einer Metallschicht bedeckt werden und wenigstens eine der zu kontaktierenden Metallschichten nach dem Transfer auf den Träger nicht mehr zugänglich ist. Die Kontaktierung wird dadurch möglich gemacht, daß die flächenhafte Halbleiterschicht nach dem Transfer auf den Träger von der dem Träger abgewandten Seite her bis auf die Metallschicht herunter entfernt wird.

- Ein schichtartiges Gebilde ist eine epitaktische Halbleiterschicht aus Schichttransferprozessen, die durch eine Separationsschicht mit dem Substrat verbunden. Das Verfahren zeichnet sich dadurch aus, daß vor dem Schichttransfer die elektronischen Bauelemente ganz oder teilweise mit einer Metallschicht bedeckt werden und wenigstens eine der zu kontaktierenden Metallschichten nach dem Transfer auf einen Träger nicht mehr zugänglich ist. Die Kontaktierung wird dadurch möglich gemacht, daß die flächenhafte Halbleiterschicht nach dem Transfer auf den Träger von der dem Träger abgewandten Seite her bis auf die Metallschicht herunter entfernt wird.
- Der Kontakt wird teilweise durch einen Prozeßschritt freigelegt, der das Metall nicht oder nur teilweise angreift.
- Der den Kontakt freilegende Prozeßschritt legt nicht nur teilweise das Metall, sondern auch Bereiche des Trägers oder Klebstoffes teilweise frei.
- Der Träger oder Klebstoff werden durch den den Kontakt freilegenden Prozeßschritt nicht oder nur schwach angegriffen (abgetragen).
- Der den Kontakt freilegende Prozeßschritt wird simultan dazu eingesetzt, die Abmessungen der Bauelemente zu definieren (Es wird ein 2-dimensionales Grabensystem hergestellt, das in den eindimensionalen Abbildungen nicht dargestellt ist.
- Der den Kontakt freilegende, die Halbleiterschicht 1 sowie ggf. den Emitterbereich 4 entfernende Prozeßschritt ist reaktives Ionenätzen.
- Der den Kontakt freilegende, die Halbleiterschicht 1 sowie ggf. den Emitterbereich 4 entfernende Prozeßschritt ist ein mechanisches Abtragen mit einer Maschine, die ähnlich funktioniert wie Chipsägen oder Drahtsägen.
- Das aufgebrachte Metall ist Al, Ti, Au, Ni, Cu, oder Pd.
- Unter dem Metall befindet sich ganz oder teilweise ein Isolator. Der Isolator kann so beschaffen sein, daß die Realisierung von Punktkontakten möglich ist.
- Das Freilegen der Kontakte erfolgt in einer Art und Weise, die gleichzeitig ein Trennen einzelner Bauelemente erzielt.
- Die freigelegten Kontakte werden durch eine Metallisierung, die von der dem Träger abgewandten Seite der Halbleiterschicht her aufgetragen wird, mit denen auf der Seite der Bauelemente verbunden, die dem Träger abgewandt ist.
- Die freigelegten Kontakte werden durch zusätzliches Metall untereinander verbunden.
- Die Bauelemente sind Dioden.
- Die Dioden sind lichtempfindlich Dioden, also Solarzellen.
- Die Verschaltung führt zu einer integrierten Serienverschaltung.

### Bezugszeichenliste

- 1: Halbleiterschicht
- 2: Substrat
- 3: Trennschicht
- 4: Emitterschicht
- 5: Träger
- 6: Klebstoff
- 7: Trennbereich
- 8: Isolator
- 9: Metall
- 10: Draht
- 11: Bereich
- 12: Bereich
- 13: Halbleiterbereich
- 14: Bereich
- 15: Metall
- 16: aufrechtstehende zufällige Pyramiden
- 16': invertierte zufällige Pyramiden
- 17: "backsurface field"-Schicht
- 18: Kontaktbus
- 19: Kontaktfinger
- 20: Trenngraben
- 22: Solarzelle
- 24: Solarzelle
- 26: Antireflexschicht
- 28: Rückseite
- 30: Kontaktgraben
- 32: Kontaktbus
- 34: Metallreflektor

## Patentansprüche

1. Verfahren zur Herstellung einer Halbleiterschaltung mit mehreren aneinander angeschlossenen aktiven und/oder passiven Bauelementen auf einem ggf. strukturierten Substrat (2) mit den folgenden Schritten:
a) es wird auf dem Substrat (2) mindestens ein p-leitender schichtartiger Bereich (1) oder ein n-leitender schichtartiger Bereich (4) und auf diesem weitere aus n-leitendem bzw. p-leitendem Material gebildete lokale Bereiche (4,1) hergestellt, wobei das Substrat (2) selbst den p-leitenden schichtartigen Bereich (1) oder den n-leitenden schichtartigen Bereich (4) bilden kann,
b) auf die freiliegende Fläche der weiteren lokalen Bereiche (4) werden, gegebenenfalls nach Strukturierung der so hergestellten Struktur, Metallkontakte (9) nach einem ausgewählten Muster angebracht,
c) die mit den Metallkontakten (9) versehene Fläche der so hergestellten Struktur wird mit einem Klebstoff (6) an ein Hilfssubstrat oder einen Träger (5) angebracht oder mit einem Klebstoff versehen, der selbst ein Hilfssubstrat bildet und das erste genannte Substrat (2) bzw. der Teil des Substrats (2), der nicht einen p-leitenden schichtartigen Bereich (1) oder einen n-leitenden schichtartigen Bereich (4) bildet, wird entfernt, **dadurch gekennzeichnet, dass**
b1) mindestens ein Metallkontakt (9) so ausgeführt ist, dass er mindestens einen aus n-leitendem bzw. p-leitendem Material bestehenden lokalen Bereich (4;1) und auch einen benachbarten aus p-leitendem bzw. n-leitendem Material bestehenden Bereich (1;4) überdeckt und
d) ein Ätzschritt durchgeführt wird, der an den Metallkontakten (9) und ggf. am Klebstoff (6) und/oder an einer gegebenenfalls vorhandenen Passivierung selbst stoppt oder gestoppt wird, durch den auf der so hergestellten Struktur auf der Seite des erstgenannten entfernten Substrats, d.h. auf der Rückseite, Bereiche (14, 30) der Struktur bis zu den genannten Metallkontakten (9) und ggf. bis zu dem Klebstoff (6) und/oder bis zur ggf. vorhandenen Passivierung entfernt werden, wodurch aus der Struktur voneinander getrennte, jedoch seriell verschaltete Halbleiterbauelemente hergestellt werden.

2. Verfahren nach Anspruch 1, **dadurch gekennzeichnet, dass** weitere Metallkontakte (15) nach einem weiteren ausgewählten Muster aufgebracht werden.

3. Verfahren nach Anspruch 1 oder 2, **dadurch gekennzeichnet, dass** im Schritt a) eine Zwischenschicht oder mehrere Zwischenschichten, bspw. eine Schicht oder mehrere Schichten aus intrinsischem Material und/oder aus p- und/oder n-leitendem Material, auf dem p-leitenden oder n-leitenden schichtartigen Bereich (1) hergestellt wird bzw. werden.

4. Verfahren nach einem der vorhergehenden Ansprüche, **dadurch gekennzeichnet, dass** auf die freiliegende Fläche der im Schritt a) hergestellten Struktur eine weitere Schicht oder mehrere weitere Schichten aufgewachsen wird bzw. werden, bevor die Metallkontakte (9) nach dem ausgewählten Muster gemäß Schritt b) angebracht werden.

5. Verfahren nach Anspruch 4, **dadurch gekennzeichnet, dass** vor Anbringung der Metallkontakte (9) nach dem ausgewählten Muster gemäß Schritt b) eine Passivierung der freiliegenden Fläche der Struktur hergestellt wird.

6. Verfahren nach Anspruch 5, **dadurch gekennzeichnet, dass** der Schritt b) der Herstellung der Metallkontakte (9) darin besteht, eine ganzflächige Metallisierung der freiliegenden Fläche der Struktur herzustellen und diese Metallisierung durch ein lithographisches Verfahren oder ein mechanisches Verfahren entsprechend dem ausgewählten Muster bereichsweise zu entfernen.

7. Verfahren nach einem der vorhergehenden Ansprüche, **dadurch gekennzeichnet, dass** der Schritt d) der Aufbringung von weiteren Metallkontakten (15) nach einem weiteren ausgewähltem Muster dadurch erfolgt, dass eine Metallisierung ganzflächig auf der Rückseite der strukturierten Struktur aufgebracht wird, und dass diese Metallisierung gegebenenfalls selbst strukturiert wird, bspw. durch ein mechanisches Abtragverfahren oder durch ein lithographisches Verfahren.

8. Verfahren zur Herstellung einer Halbleiterschaltung mit mehreren aneinander angeschlossenen aktiven und/oder passiven Bauelementen auf einem ggf. strukturierten Substrat (2), mit den folgenden Schritten:
a) es wird auf einem Substrat (2) mindestens ein p-leitender oder n leitender schichtartiger Bereich (1) hergestellt und auf diesem direkt oder indirekt, d. h. mit einer oder mehreren Zwischenschichten, beispielsweise einer Schicht oder mehreren Schichten aus intrinsischem Material und/oder aus p-und/oder n-leitenden Material, mindestens ein weiterer n-leitender bzw. p-leitender Bereich (4) hergestellt, wobei das Substrat (2) selbst den p-leitenden schichtartigen Bereich oder den n-leitenden schichtartigen Bereich bilden kann,
b) auf die freiliegende Fläche des mindestens einen weiteren n-leitenden bzw. p-leitenden Bereichs (4) wird bzw. werden direkt oder indirekt, d. h. mit einer Zwischenschicht oder mit mehreren Zwischenschichten, gegebenenfalls nach Strukturierung der so hergestellten Struktur und gegebenenfalls nach Anbringung einer Passivierung, eine Metallisierung bzw. Metallkontakte (9) an ausgewählten Stellen bzw. nach einem ausgewählten Muster angebracht,
c) die mit den Metallkontakten (9) versehene Fläche der so hergestellten Struktur wird unmittelbar oder nach weiterer Strukturierung bzw. nach Anbringung einer weiteren Schicht oder mehreren weiteren Schichten oder Schichtbereichen mittels eines Klebstoffs (6), vorzugsweise aus einem Kunststoff, an ein Hilfssubstrat (5) angebracht oder mit einem Klebstoff (6) versehen, der selbst ein Hilfssubstrat bildet, und das erstgenannte Substrat (2) bzw. der Teil des Substrats (2), der nicht einen p-leitenden schichtartigen Bereich (1) oder einen n-leitenden schichtartigen Bereich (4) bildet, wird entfernt,
d) ein Ätzschritt wird durchgeführt, der an den Metallkontakten (9) bzw. an der Metallisierung und ggf. am Klebstoff (6) und/oder an einer gegebenenfalls vorhandenen Passivierung selbst stoppt oder gestoppt wird, durch den auf der Seite des erstgenannten Substrats die Struktur, die auf dem erstgenannten Substrat hergestellt wird, stellenweise bis zu den Metallkontakten (9) entfernt wird, wodurch voneinander getrennte Halbleiterbauelemente hergestellt werden,
e) auf der Seite des erstgenannten Substrats (2) wird ggf. nach der Herstellung von einem oder mehreren weiteren Schichten auf die so gebildete Seite, eine weitere Metallisierung oder weitere Metallkontakte (15) nach einem weiteren ausgewähltem Muster aufgebracht, wobei
die weitere Metallisierung oder die weiteren Metallkontakte (15) ausgewählte erstgenannte Metallkontakte (9) kontaktieren, wobei zwischen benachbarten Halbleiterbauelementen eine Serienverschaltung hergestellt wird.

9. Verfahren nach einem der vorhergehenden Anspüche, **dadurch gekennzeichnet, dass** der Ätzschritt, entweder durch Plasmaätzen oder durch einen reaktiven Ionenätzschritt durchgeführt wird.

10. Verfahren nach Anspruch 8, **dadurch gekennzeichnet, dass** nach dem Schritt e) die aufgebrachte Metallisierung (15) als Maske für die Entfernung von Halbleiterbereichen verwendet wird, die sich zwischen den metallisierten Bereichen befinden.

## Claims

1. A method of manufacturing a semiconductor circuit having a plurality of active and/or passive components connected to one another at an optionally structured substrate (2) comprising the following steps of:
a) at least one p-conducting layer-like region (1) or an n-conducting layer-like region (4) is manufactured on the substrate (2) and further local regions (4, 1) composed of n-conducting material and/or of p-conducting material are manufactured on this, wherein the substrate (2) itself can form the p-conducting layer-like region (1) or the n-conducting layer-like region (4);
b) applying metal contacts (9) in accordance with a selected pattern on the free lying surface of the further local regions (4) optionally after a structuring of the so established structure;
c) attaching the surface having the metal contacts (9) of the so established structure to an auxiliary substrate or to a support (5) by means of an adhesive (6) or providing the surface having the metal contacts (9) of the so established structure with an adhesive, said adhesive itself forming an auxiliary substrate and removing the first said substrate (2) or a part of the substrate (2) which does not form a p-conducting layer-like region (1) or an n-conducting layer-like region (4), **characterized in that**
b1) at least one metal contact (9) is designed in such a way that it covers at least one local region (4; 1) composed of an n-conducting material and/or of a p-conducting material as well as covering an adjacent region (1; 4) composed of a p-conducting material and/or an n-conducting material; and **in that**
d) an etching step is carried out which stops or is stopped at the metal contacts (9) and optionally at the adhesive (6) and/or at an optionally present passivation, by means of which regions (14, 30) of the structure are removed up to the said metal contacts (9) and optionally up to the adhesive (6) and/or up to the optionally present passivation at the so established structure at the side of the first said removed substrate, this means at the rear side, whereby semiconductor components separate from one another but serially connected to one another are manufactured from the structure.

2. A method in accordance with claim 1, **characterized in that** further metal contacts (15) are applied in accordance with a further selected pattern.

3. A method in accordance with claim 1 or claim 2, **characterized in that**, during step a) an intermediate layer or a plurality of an intermediate layers, for example, a layer or a plurality of layers of intrinsic material and/or of p-conducting material and/or of n-conducting material is/are established on the p-conducting layer-like region or on the n-conducting layer-like region (1).

4. A method in accordance with any one of the preceding claims, **characterized in that** a further layer or a plurality of further layers are grown on the free lying surface of the structure manufactured in step a) before the metal contacts (9) are applied in accordance with the selected pattern according to step b).

5. A method in accordance with claim 4, **characterized in that** prior to the application of the metal contacts (9) in accordance with the selected pattern according to step b) a passivation of the free lying surface of the structure is established.

6. A method in accordance with claim 5, **characterized in that** the step b) the step of manufacturing the metal contacts (9) consists therein in establishing a whole-area-wise metallization of the free lying surface of the structure and to regionally remove this metallization in accordance with the selected pattern by means of a lithographic method or by means of a metallic method.

7. A method in accordance with any one of the preceding claims, **characterized in that** the step d) the step of applying further metal contacts (15) in accordance with a further selected pattern is established **in that** a metallization is applied whole-area-wise at the rear side of the structured structure and **in that** this metallization itself is optionally structured, for example, by means of a mechanical separation method or by means of a lithographic method.

8. A method of manufacturing a semiconductor circuit having a plurality of active and/or passive components connected to one another at an optionally structured substrate (2), comprising the following steps:
a) at least one p-conducting or an n-conducting layer-like region (1) is manufactured on a substrate (2) and at least one further n-conducting and/or p-conducting region (4) is manufactured directly or indirectly on this, that means having one or more intermediate layers, for example, a layer or a plurality of layers of intrinsic material, and/or of a p-conducting material and/or of an n-conducting material, wherein the substrate (2) itself can form the p-conducting layer-like region or the n-conducting layer-like region;
b) applying a metallization and/or metal contacts (9) at selected positions and/or in accordance with a selected pattern directly or indirectly on the free lying surface of the at least one further n-conducting and/or p-conducting region (4), that means having an intermediate layer or having a plurality of intermediate layers, optionally after a structuring of the so established structure and optionally after application of a passivation;
c) attaching the surface provided with the metal contacts (9) of the so established structure directly or following further structurization and/or after application of a further layer or of a plurality of further layers or layer regions to an auxiliary substrate (5) by means of an adhesive (6) preferably composed of a plastic, or providing the surface provided with the metal contacts with an adhesive (6), said adhesive itself forming an auxiliary substrate and removing the first said substrate (2) or a part of the substrate (2) which does not form a p-conducting layer-like region (1) or an n-conducting layer-like region (4);
d) carrying out an etching step which is stopped or stops at the metal contacts (9) and/or at the metallization and optionally at the adhesive (6) and/or at an optionally present passivation by means of which the structure which is established on the first said substrate at the side of the first said substrate is partly removed up to the metal contacts (9), whereby semiconductor components separate from another are established;
e) applying a further metallization or further metal contacts (15) in accordance with a further selected pattern at the side of the first said substrate (2) optionally after the manufacture of one or more further layers on the so-formed side; wherein
the further metallization or the further metal contacts (15) contact selected first said metal contacts (9), wherein a series circuit is established between adjacent semiconductor components.

9. A method in accordance with any one of the preceding claims, **characterized in that** the etching step is carried out either by means of plasma etching or by means of a reactive ion etching step.

10. A method in accordance with claim 8, **characterized in that**, following the step e), the applied metallization (15) is used as a mask for the removal of semiconductor regions which are present between the metallized regions.

## Revendications

1. Procédé pour la production d'un circuit semi-conducteur comprenant plusieurs composants actifs et/ou passifs branchés les uns aux autres sur un substrat (2) éventuellement structuré, comprenant les étapes suivantes :
a) on réalise sur le substrat (2) au moins une zone (1) semblable à une couche à conduction p ou bien une zone (4) semblable à une couche à conduction n et on réalise sur cette zone d'autres zones locales (4, 1) formées en matériau à conduction n ou p, dans lequel le substrat (2) peut former lui-même la zone (1) semblable à une couche à conduction p ou la zone (4) semblable à une couche à conduction n,
b) sur la surface libre des autres zones locales (4), on applique, le cas échéant après structuration de la structure ainsi produite, des contacts métalliques (9) selon un motif sélectionné,
c) la surface, pourvue des contacts métalliques (9), de la structure ainsi produite est appliquée avec une colle (6) sur un substrat auxiliaire ou sur un support (5), ou encore pourvue d'une colle qui forme elle-même un substrat auxiliaire, et le premier substrat précité (2) ou respectivement la partie du substrat (2) qui ne forme par une zone (1) semblable à une couche à conduction p ou une zone (4) semblable à une couche à conduction n est supprimé(e),
**caractérisé en ce que**
b1) au moins un contact métallique (9) est réalisé de telle façon qu'il recouvre au moins une zone locale (4 ; 1) constituée en matériau à conduction n ou p, ainsi qu'une zone voisine (1 ; 4) constituée en matériau à conduction p ou n, et
d) on exécute une étape d'attaque, qui s'arrête d'elle-même ou qui est arrêtée au niveau des contacts métalliques (9) et le cas échéant au niveau de la colle (6) et/ou au niveau d'une passivation éventuellement prévue, attaque par laquelle on supprime, sur la structure ainsi produite et du côté du premier substrat précité supprimé, c'est-à-dire sur le côté postérieur, des zones (14, 30) de la structure jusqu'aux contacts métalliques précités (9) et le cas échéant jusqu'à la colle (6) et/ou jusqu'à une passivation éventuellement prévue, grâce à quoi on produit à partir de la structure des composants semi-conducteurs séparés les uns des autres mais branchés en série.

2. Procédé selon la revendication 1, **caractérisé en ce que** l'on applique d'autres contacts métalliques (15) selon un autre motif sélectionné.

3. Procédé selon la revendication 1 ou 2, **caractérisé en ce que** dans l'étape a) on produit une couche ou plusieurs couches en matériau intrinsèque et/ou en matériau à conduction p et/ou n, sur la zone (1) semblable à une couche à conduction p ou n.

4. Procédé selon l'une des revendications précédentes, **caractérisé en ce que** l'on fait croître sur la surface libre de la structure produite dans l'étape a) une ou plusieurs autres couches avant d'appliquer les contacts métalliques (9) selon le motif sélectionné selon l'étape b).

5. Procédé selon la revendication 4, **caractérisé en ce que**, avant application des contacts métalliques (9) selon le motif sélectionné d'après l'étape b), on réalise une passivation de la surface libre de la structure.

6. Procédé selon la revendication 5, **caractérisé en ce que** l'étape b) de la production des contacts métalliques (9) consiste à réaliser une métallisation de toute la surface de la surface libre de la structure, et à supprimer cette métallisation par zone par un procédé lithographique ou par un procédé mécanique de manière correspondant au motif sélectionné.

7. Procédé selon l'une des revendications précédentes, **caractérisé en ce que** l'étape d) d'application d'autres contacts métalliques (15) selon un autre motif sélectionné a lieu en appliquant une métallisation sur toute la surface du côté postérieur de la structure structurée, et **en ce que** cette métallisation est elle-même le cas échéant structurée, par exemple par un procédé d'enlèvement mécanique ou par un procédé lithographique.

8. Procédé pour la production d'un circuit semi-conducteur comprenant plusieurs composants actifs et/ou passifs branchés les uns aux autres sur un substrat (2) éventuellement structuré, comprenant les étapes suivantes :
a) on réalise sur le substrat (2) au moins une zone (1) semblable à une couche à conduction p ou à conduction n et on réalise sur celle-ci au moins une autre zone (4) à conduction n ou à conduction p soit directement soit indirectement, c'est-à-dire avec une ou plusieurs couches intermédiaires, comme par exemple une couche ou plusieurs couches en matériau intrinsèque et/ou en matériau à conduction p et/ou à conduction n, dans lequel le substrat (2) lui-même peut former la zone semblable à une couche à conduction p ou la zone semblable à une couche à conduction n,
b) sur la surface libre de ladite au moins une autre zone (4) à conduction n ou à conduction p, on applique une métallisation ou des contacts métalliques (9), à des emplacements sélectionnés ou respectivement selon un motif sélectionné, soit directement soit indirectement, c'est-à-dire avec une couche intermédiaire ou avec plusieurs couches intermédiaires, le cas échéant après structuration de la structure ainsi produite et le cas échéant après application d'une passivation,
c) la surface pourvue des contacts métalliques (9) de la structure ainsi produite est appliquée, soit directement soit après une autre structuration ou respectivement après application d'une autre couche ou de plusieurs autres couches ou de zones de couches et au moyen d'une colle (6), de préférence en matière plastique, sur un substrat auxiliaire (5), ou bien est pourvue d'une colle (6) qui forme elle-même un substrat auxiliaire, et le premier substrat précité (2) ou respectivement la partie du substrat (2) qui ne forme pas une zone (1) semblable à une couche à conduction p ou une zone (4) semblable à une couche à conduction n, est supprimé(e),
d) on exécute une étape d'attaque, qui s'arrête d'elle-même ou qui est arrêtée au niveau des contacts métalliques (9) ou au niveau de la métallisation et le cas échéant au niveau de la colle (6) et/ou au niveau d'une passivation éventuellement prévue, attaque par laquelle on supprime, sur le côté du premier substrat précité, la structure qui a été produite sur le premier substrat précité, localement jusqu'aux contacts métalliques (9), grâce à quoi on produit des composants semi-conducteurs séparés les uns des autres,
e) sur le côté du premier substrat précité (2) et le cas échéant après production d'une ou plusieurs autres couches sur le côté ainsi formé, on applique une autre métallisation ou d'autres contacts métalliques (15) selon un autre motif sélectionné, et l'autre métallisation ou les autres contacts métalliques (5) viennent en contact avec des contacts sélectionnés parmi les premiers contacts métalliques précités (9), de sorte que l'on produit un branchement en série entre des composants semi-conducteurs voisins.

9. Procédé selon l'une des revendications précédentes, **caractérisé en ce que** l'étape d'attaque est exécutée soit par attaque au plasma soit par une étape d'attaque ionique réactive.

10. Procédé selon la revendication 8, **caractérisé en ce que**, après l'étape e), la métallisation appliquée (15) est utilisée comme masque pour l'enlèvement de zones semiconductrices qui se trouvent entre les zones métallisées.
